# EUROPÄISCHE PATENTSCHRIFT

(11) **EP 0 590 742 B1**
(45) Veröffentlichungstag und Bekanntmachung des Hinweises auf die Patenterteilung: **03.04.1996**
(21) Anmeldenummer: 93250238.8
(22) Anmeldetag: 03.09.1993
(51) Int. Cl.: H05K 7/14

(54) **Einschiebbare elektrische Geräteeinheit**
Electical drawer-like apparatus
Appareillage electrique sur tiroir

(30) Priorität: 28.09.1992 DE 4232918
(43) Veröffentlichungstag der Anmeldung: 06.04.1994
(73) Patentinhaber: SIEMENS AKTIENGESELLSCHAFT, D-80333 München (DE)
(72) Erfinder: Genzel, Rolf-Günter, D-64750 Lützelbach (DE); Bruszies, Christian, D-73760 Ostfildern (DE); Braun, Bodo, D-63071 Offenbach (DE); Lobnig, Josef, D-91074 Herzogenaurach (DE); Raddatz, Jürgen, D-60385 Frankfurt (DE); Ganser, Bodo, D-63517 Rodenbach (DE); Festerling, Walter, D-59174 Kamen (DE); Feuerbach, Manfred, D-60389 Frankfurt (DE)

(56) Entgegenhaltungen:
- EP-A- 0 109 569
- EP-A- 0 351 315
- DE-A- 3 243 134
- DE-U- 8 908 028
- US-A- 4 502 047

## Beschreibung

Die Erfindung betrifft eine in ein Traggerüst einschiebbare elektrische Geräteeinheit mit einem aus Blech bestehenden Träger, auf dem Träger angeordneten, Anschlußklemmen aufweisenden Schalt- und Steuergeräten und einer sich Zwischen den Schalt- und Steuergeräten und/oder zwischen den Schalt- und Steuergeräten und den Trennkontakten erstreckenden, Verbindungsleitungen aufweisenden und in einen an dem Träger befindlichen, durch eine Abkantung gebildeten U-förmigen Kanal einlegbaren Verdrahtung.

Eine Geräteeinheit dieser Art ist durch die DE-A-32 43 134 bekannt geworden. Durch die Kanäle wird die Verdrahtung gegen Beschädigungen relativ gut geschützt. Je besser jedoch die Lage und die Form der Kanäle an den Schutzzweck angepaßt wird, um so schwieriger ist das Einlegen der Leitungen in die Kanäle. Der Erfindung liegt hiervon ausgehend die Aufgabe zugrunde, bei gleichfalls gutem Schutz der Verdrahtung ihre Herstellung zu erleichtern.

Gemäß der Erfindung wird diese Aufgabe dadurch gelöst, daß die Abkantung Bestandteil eines ersten Teilstückes des Trägers ist und mit ihrer offenen Seite den Anschlußklemmen zugewandt angeordnet ist, daß der Träger eine das erste Teilstück begrenzende, durch einen zumindest örtlich verminderten Querschnitt gebildete erste Biegezone besitzt und daß das erste Teilstück in Richtung der Anschlußklemmen entlang der ersten Biegezone hochstellbar ist.

Das Leitungsbündel läßt sich dann in den U-Kanal einlegen. Die endgültige geschützte Unterbringung der Leitungen geschieht erst zum Schluß des Herstellungsganges der Geräteeinheit dadurch, daß das erwähnte erste Teilstück des Trägers durch Biegen entlang der Biegezone mit örtlich vermindertem Querschnitt gebogen bzw. hochgestellt wird. Auf diese Weise wird der U-Kanal durch eine weitere Wand derart ergänzt, daß ein Schutzraum für die Verdrahtung entsteht.

Durch das DE-GM 89 08 028 ist es an sich bekannt, ein Gehäuse als Blechformteil mit perforierten Biegekanten auszubilden. Die Einbeziehung von Leitungskanälen wurde dabei aber nicht in Betracht gezogen. Vielmehr wurde ein fertiger Leitungskanal an das gleichfalls fertiggestellte Gehäuse angefügt.

Nach einer vorteilhaften Weiterbildung der Erfindung können auch die zu Trennkontakten führenden Leitungen der Geräteeinheit in die beschriebene Vorgehensweise einbezogen werden. Dies kann dadurch geschehen, daß die Trennkontakte an einem zweiten Teilstück des Trägers angebracht sind, das entlang einer rechtwinklig zu der Abkantung des ersten Teilstückes verlaufenden Linie zur Bildung einer zweiten Biegezone ebenfalls örtlich einen verringerten Querschnitt besitzt.

Die Herstellung einer Gräteeinheit nach der Erfindung kann vorzugsweise nach folgenden Schritten erfolgen:
a) Die benötigten Schalt- und Steuergeräte werden auf dem Träger mit Ausrichtung ihrer Anschlußklemmen auf Abkantung montiert,
b) die Verbindungsleitungen werden an den Schalt- und Steuergeräten und an den Trennkontakten angeschlossen,
c) die Verbindungleitungen werden in die Abkantung eingelegt,
d) das mit den Trennkontakten versehene zweite Teilstück des Trägers wird entlang der zweiten Biegezone rechtwinklig hochgestellt und
e) das mit der Abkantung versehene erste Teilstück wird entlang der ersten Biegezone gleichfalls rechtwinklig hochgestellt.

Bei dem vorstehend angegebenen Verfahren ist es nicht erforderlich, daß die Verbindungsleitungen eine genau vorbestimmte Länge besitzen, die genau an den Abstand der Klemmen bzw. der Klemmen von den Trennkontakten angepaßt ist. Auf diese Weise ist es möglich, eine etwas größere Leitungslänge zu wählen, die das Anschließen erleichtert. Unter Umständen können sogar einheitliche Leitungslängen für alle vorgesehenen Verbindungen gewählt werden. Ist die gesamte Verdrahtung fertiggestellt, so lassen sich alle Leitungen zusammenfassen und in einer mehr oder weniger ausgeprägten Schlaufe in die Abkantung einlegen. Nach dem Hochstellen der Teilstücke des Trägers sind die Leitungen in ähnlicher Weise gesichert, wie dies beim Einlegen in vorbereitete Kanäle der Fall ist.

Die erst nachträgliche Bildung eines Leitungskanals auf der Geräteeinheit durch das Hochstellen von Teilstücken hat noch den Vorteil, daß eine elektrische Funktionsprüfung vorgenommen werden kann, bevor die Leitungen durch das Hochstellen der Teilstücke des Trägers weitgehend verdeckt sind. Sollte ein Fehler gefunden werden, so ist in dem Zwischenstadium die Behebung des Fehlers, das Umstecken einer Leitung oder das nachträgliche Einfügen einer fehlenden Leitung vergleichsweise einfach.

Die Bildung von Biegezonen an Blechteilen durch einen örtlich geschwächten Querschnitt ist an sich bekannt. Biegezonen der erwähnten Art lassen sich auf unterschiedliche Weise bilden. Beispielsweise kann eine Blechtafel zur Bildung der Biegezone entlang einer Linie durch Einprägen entlang der ganzen Länge gebildet werden. Zweckmäßig, und in den üblichen Fertigungsgang von Blechteilen gut einzufügen ist die Bildung der Biegezone durch eine aufeinanderfolgende Reihe von schmalen Durchbrüchen, zwischen denen jeweils ein später zu biegender Steg verbleibt. Eine für den vorliegenden Anwendungszweck erwünschte relativ scharfkantige Biegung wird dadurch begünstigt, daß die Durchbrüche beidseitig der ideellen Biegelinie versetzt angeordnet werden.

Die Erfindung wird im folgenden anhand des in den Figuren dargestellten Ausführungsbeispieles näher erläutert.

Die Figur 1 zeigt eine im Aufbau befindliche Geräteeinheit mit montierten Geräten, jedoch noch fehlender Verdrahtung.

In der Figur 2 ist die Geräteeinheit gemäß der Figur 1 durch die benötigten Leitungen ergänzt gezeigt.

Die Figur 3 zeigt die Geräteeinheit mit einem hochgestellten, Trennkontakte aufweisenden Teilstück.

In der Figur 4 ist die Geräteeinheit nach den vorangehenden Figuren im fertigen Zustand dargestellt.

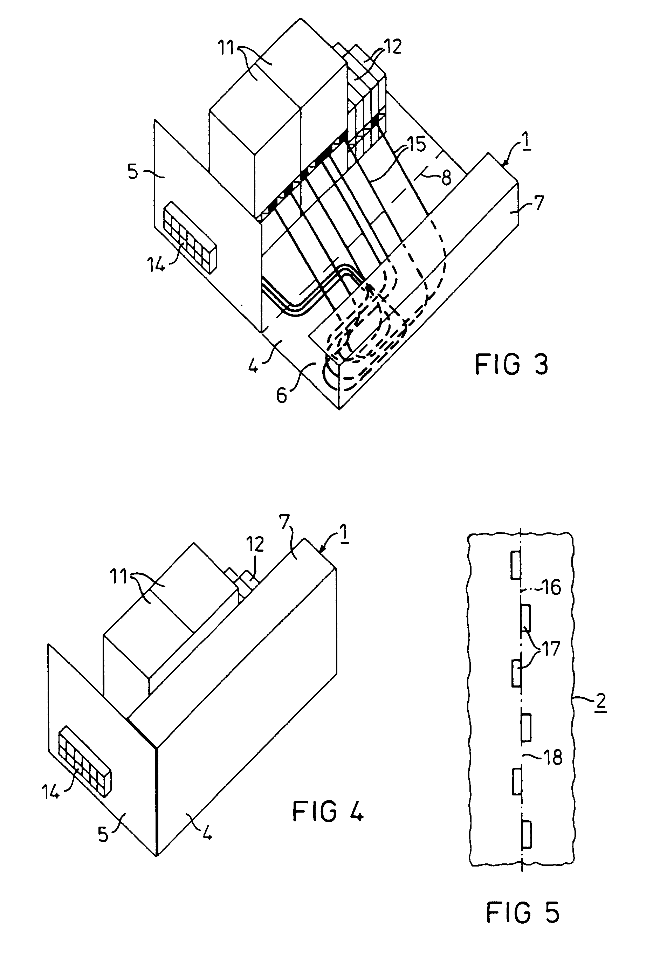

Einzelheiten einer Biegezone zeigt die Figur 5.

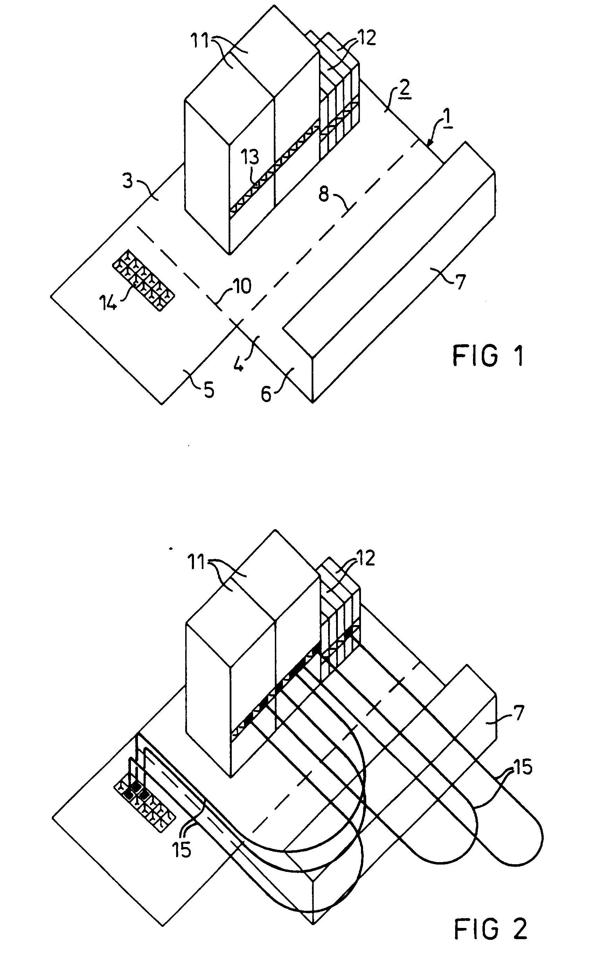

Die Geräteeinheit 1 gemäß der Figur 1 weist einen aus Blech bestehenden Träger 2 auf, der eine rechteckige Montagefläche 3 für Geräte sowie ein erstes Teilstück 4 und ein zweites Teilstück 5 aufweist. Das erste Teilstück 4 besitzt an seinem Ende einen sich über die ganze Länge erstreckenden U-förmigen Kanal 6, der durch eine Abkantung 7 gebildet ist. Zwischen der Montagefläche 3 und dem ersten Teilstück 4 befindet sich eine erste Biegezone 8, die durch eine gestrichelte Linie angedeutet ist. Beispielsweise kann jeder der Teilstriche dieser die Biegezone 8 darstellenden Linie eine schmale rechteckige Durchbrechung des Bleches darstellen. Vorzugsweise können diese schmalen Durchbrechungen gegeneinander versetzt sein, was jedoch in der Figur 1 nicht gezeigt ist.

Ein zweites Teilstück 5 des Trägers 2 geht von einer der Schmalseiten der Montagefläche 3 aus und besitzt eine zweite Biegezone 10, die sich somit rechtwinklig zu der ersten Biegezone 8 erstreckt.

Wie die Figur 1 zeigt, sind auf der Montagefläche 3 des Trägers 2 schematisch dargestellte Geräte angeordnet, beispielsweise zwei Schütze 11 sowie Relais 12 oder ähnliche Geräte. Alle Geräte sind so montiert, daß ihre Anschlußklemmen 13 der Abkantung gegenüberstehen, was sich vorteilhaft auf die Anbringung der Verdrahtung auswirkt. In dem zweiten Teilstück 5 des Trägers 2 sind vorzugsweise für Steuerleitungen vorgesehene Trennkontakte 14 in Gestalt eines Vielfachsteckers bzw. einer Vielfachsteckbuchse angeordnet.

Die Figur 2 veranschaulicht, wie die benötigten elektrischen Verbindungen hergestellt werden. Es kann sich dabei sowohl um Verbindungen der Geräte 11 und 12 untereinander als auch zwischen den Geräten und einzelnen Kontakten des Trennkontaktblockes handeln. Beide Arten von Verbindungen sind in der Figur 2 gezeigt. Wesentlich ist hierbei, daß die mit 15 bezeichneten Verbindungsleitungen bogen- oder U-förmig verlegt werden, wobei eine bestimmte Länge nicht eingehalten zu werden braucht. Unter Umständen können alle Verbindungsleitungen 15 in einheitlicher Länge konfektiert werden, so daß ihr Überstand über die Abkantung 7 entsprechend der Figur 2 zunächst unterschiedlich ausfällt, je nach dem ob nahe beieinander oder weiter voneinander entfernte Punkte zu verbinden sind.

In dem Zustand der Geräteeinheit 1 gemäß der Figur 2 liegt eine bereits funktionsfähige Schaltung vor. Diese ist daher für eine elektrische Prüfung der Geräteeinheit 1 besonders geeignet, weil die Leitungen 15 gut zugänglich sind und leicht ausgewechselt, umgesteckt oder im Bedarfsfall nachträglich eingefügt werden können, fall ein Fehler festgestellt werden sollte.

Die Figur 3 zeigt einen sich anschließenden Zwischenstand im Herstellungsvorgang der Geräteeinheit 1, bei dem die Gesamtheit der Verbindungsleitungen 15 durch Umbiegen in die Abkantung 7 des Teilstückes 4 eingelegt ist. Ferner ist das zweite Teilstück 5 mit dem Trennkontaktblock 14 bereits entlang der Biegelinie 10 rechtwinklig hochgestellt.

Die Figur 4 zeigt die Geräteeinheit 1 im fertiggestellten Zustand, der sich von dem Zuvor gezeigten Zustand dadurch unterscheidet, daß das erste Teilstück 4 entlang der ersten Biegezone 8 gleichfalls rechtwinklig hochgestellt ist, wodurch die gesamte Verdrahtung ausreichend festgelegt, verdeckt und geschützt ist. Durch die rechtwinklige Stellung der Teilstücke 4 und 5 wird dabei ein Austreten der Verbindungsleitungen 15 am einen Ende des durch die Abkantung 7 gebildeten Kanals verhindert.

Eine geeignete Ausbildung einer der erwähnten Biegezonen 8 bzw. 10 Zeigt die Figur 5. Diese stellt einen Ausschnitt des Trägers 2 dar, wobei eine ideelle Biegelinie 16 strichpunktiert angedeutet ist. Beidseitig der Biegelinie 16 ist der Träger 2 in versetzter Folge mit schmalen rechteckigen Durchbrechungen 17 versehen. An einem Biegevorgang nehmen hauptsächlich die zwischen den Durchbrechungen 17 verbleibenden Stege 18 teil, während die anschließenden Bereiche des Trägers 2 weitgehend unbeeinflußt bleiben.

Nach dem beschriebenen Prinzip können auch umfangreiche Geräteeinheiten hergestellt werden, indem z. B. zwei Teilstücke mit einer Abkantung 7 und zwei Reihen von Schaltgeräten mit zur anderen Seite weisenden Anschlußklemmen vorgesehen werden. Ebenso wäre es möglich, ein weiteres Teilstück des Trägers 2 mit einer weiteren Trennkontakteinheit am gegenüberliegenden Ende der Montagefläche 3 vorzusehen.

### Bezugszeichenliste

- 1 =: Geräteeinheit als Ganzes
- 2 =: Träger der Geräteeinheit 1
- 3 =: Montagefläche des Trägers 2
- 4 =: erstes Teilstück des Trägers 2
- 5 =: zweites Teilstück des Trägers 2
- 6 =: Kanal für Leitungen
- 7 =: Abkantung des ersten Teilstückes 4
- 8 =: erste Biegezone zwischen Montagefläche 3 und Teilstück 4
- 10 =: zweite Biegezone zwischen Montagefläche 3 und Teilstück 5
- 11 =: Schutz (Beispiel für Schaltgerät)
- 12 =: Relais (Beispiel für Steuergerät)
- 13 =: Anschlußklemme
- 14 =: Trennkontaktblock
- 15 =: Verbindungsleitung
- 16 =: ideelle Biegelinie
- 17 =: Durchbrechung
- 18 =: Steg

## Patentansprüche

1. In ein Taggerüst einschiebbare elektrische Geräteeinheit (1) mit einem aus Blech bestehenden Träger (2), auf dem Träger (2) angeordneten, Anschlußklemmen (13) aufweisenden Schalt- und Steuergeräten (11, 12) und einer sich zwischen den Schalt- und Steuergeräten (11, 12) und/oder zwischen den Schalt- und Steuergeräten (11, 12) und Trennkontakten (14) erstreckenden, Verbindungsleitungen (15) aufweisenden und in einen an dem Träger (2) befindlichen, durch eine Abkantung (7) gebildeten U-förmigen Kanal (6) einlegbaren Verdrahtung,
**dadurch gekennzeichnet**, daß die Abkantung (7) Bestandteil eines ersten Teilstückes (4) des Trägers (2) ist und mit ihrer offenen Seite den Anschlußklemmen (13) zugewandt angeordnet ist, daß der Träger (2) eine das erste Teilstück (4) begrenzende, durch einen zumindest örtlich verminderten Querschnitt gebildete erste Biegezone (8) besitzt und daß das erste Teilstück (4) in Richtung der Anschlußklemmen (13) entlang der ersten Biegezone (8) hochstellbar ist.

2. Geräteeinheit nach Anspruch 1,
**dadurch gekennzeichnet**, daß die Trennkontakte (14) an einem zweiten Teilstück (5) des Trägers (2) angebracht sind, das entlang einer rechtwinklig zu der Abkantung (7) des ersten Teilstückes (4) verlaufenden Linie zur Bildung einer zweiten Biegezone (10) ebenfalls örtlich einen verringerten Querschnitt besitzt und daß das zweite Teilstück (5) entlang der zweiten Biegezone (10) hochstellbar ist.

3. Verfahren zur Herstellung einer Geräteeinheit nach Anspruch 1 und 2,
**gekennzeichnet durch** folgende Schritte:
a) die benötigten Schalt- und Steuergeräte (11, 12) werden auf dem Träger (2) mit Ausrichtung ihrer Anschlußklemmen (13) auf die Abkantung (7) montiert,
b) die Verbindungsleitungen (15) werden an den Schalt- und Steuergeräten (11, 12) und an den Trennkontakten (14) angeschlossen,
c) die Verbindungsleitungen (15) werden in den U-förmigen Kanal (6) eingelegt,
d) das mit den Trennkontakten (14) versehene zweite Teilstück (5) des Trägers (2) wird entlang der zweiten Biegezone (10) rechtwinklig hochgestellt, und
e) das mit der Abkantung (7) versehene erste Teilstück (4) wird entlang der ersten Biegezone (8) gleichfalls rechtwinklig hochgestellt.

## Claims

1. Electrical apparatus unit (1), which can be pushed into a supporting frame, having a carrier (2) which consists of sheet metal, having switching and control apparatus (11, 12) which are arranged on the carrier (2) and have connection terminals (13), and having wiring which extends between the switching and control apparatus (11, 12) and/or between the switching and control apparatus (11, 12) and isolating contacts (14), has connecting leads (15) and can be inserted into a U-shaped channel (6) which is located on the carrier (2) and is formed by a folded edge (7),
characterised in that the folded edge (7) is part of a first section (4) of the carrier (2) and is arranged with its open side facing the connection terminals (13), in that the carrier (2) has a first bending zone (8) which delimits the first section (4) and is formed by a cross section which is diminished at least locally and in that the first section (4) can be turned up in the direction of the connection terminals (13) along the first bending zone (8).

2. Apparatus unit according to claim 1,
characterised in that the isolating contacts (14) are provided on a second section (5) of the carrier (2) that has, likewise locally, a diminished cross section along a line, which extends at right angles to the folded edge (7) of the first section (4), so as to form a second bending zone (10) and in that the second section (5) can be turned up along the second bending zone (10).

3. Method for producing an apparatus unit according to claim 1 and 2, characterised by the following steps:
a) the required switching and control apparatus (11, 12) are mounted on the carrier (2) with their connection terminals (13) aligned with the folded edge (7),
b) the connecting leads (15) are connected to the switching and control apparatus (11, 12) and to the isolating contacts (14),
c) the connecting leads (15) are inserted into the U-shaped channel (6),
d) the second section (5) of the carrier (2) that is provided with the isolating contacts (14) is turned up at right angles along the second bending zone (10), and
e) the first section (4) which is provided with the folded edge (7) is turned up likewise at right angles along the first bending zone (8).

## Revendications

1. Unité électrique d'appareils (1), qui peut être insérée dans un châssis de support et comporte un support (2) formé d'une tôle, et des appareils de coupure et de commande (11,12) disposés sur le support (2) et comportant des bornes de raccordement (13), et un câblage qui s'étend entre les appareils de coupure et de commande (11,12) et/ou entre les appareils de coupure et de commande (11,12) et des contacts de coupure (14), et comporte des lignes de raccordement (15) et peut être insérée dans un conduit en forme de U (6) situé sur le support (2) et formé par un élément replié (7), caractérisée par le fait que l'élément replié (7) fait partie d'une première partie (4) du support (2) et est disposée de telle sorte que son côté ouvert est tourné vers les bornes de raccordement (13), que le support (2) possède une première zone de pliage (8) qui délimite la première partie (4) et est formée par une section transversale au moins réduite localement, et que la première partie (4) peut être rabattue vers le haut en direction des bornes de raccordement (13) le long de la première zone de pliage (8).

2. Unité d'appareils suivant la revendication 1, caractérisée par le fait que les contacts de coupure (14) sont disposés sur une seconde partie (5) du support (2), qui localement possède également une section transversale réduite, le long d'une droite, qui s'étend perpendiculairement à l'élément replié (7) de la première partie (4) pour la formation d'une seconde zone de pliage (10) et que la seconde partie (5) peut être rabattue vers le haut le long de la seconde ligne de pliage (10).

3. Procédé pour fabriquer une unité d'appareils suivant les revendications 1 et 2, caractérisé par les étapes suivantes :
a) on installe les appareils de coupure et de commande nécessaires (11,12) sur le support (2) en alignant leurs bornes de raccordement (13) sur l'élément replié (7),
b) on raccorde la ligne de liaison (15) aux appareils de coupure et de commande (11,12) et aux contacts de coupure (14),
c) on insère les lignes de liaison (15) dans le canal en forme de U (6),
d) on rabat vers le haut, perpendiculairement le long de la seconde zone de pliage (10), la seconde partie (5) du support (2), qui est pourvue des contacts de coupure (14), et
e) on rabat également vers le haut, le long de la première zone de pliage (8), la première partie (4) pourvue de l'élément replié (7).
